Europäisches Patentamt

European Patent Office

Office européen des brevets

(19)

(11) Publication number : **0 409 150 B1**

# EUROPEAN PATENT SPECIFICATION

(12)

(45) Date of publication of patent specification :
**12.10.94 Bulletin 94/41**

(51) Int. Cl.$^5$: **H01L 39/14, H01L 39/24**

(21) Application number : **90113620.0**

(22) Date of filing : **16.07.90**

(54) **Superconducting wire.**

(30) Priority : **19.07.89 JP 188597/89**

(43) Date of publication of application :
**23.01.91 Bulletin 91/04**

(45) Publication of the grant of the patent :
**12.10.94 Bulletin 94/41**

(84) Designated Contracting States :
**DE FR GB**

(56) References cited :
**EP-A- 0 305 820**
**EP-A- 0 357 779**
**JAPANESE JOURNAL OF APPLIED PHYSICS,
vol. 28, no. 7, July 1989, pages 1185-1188, JP;
H. SEKINE et al.: "Metallurgical studies and
optimization of critical current density in Bi-
(Pb)-Sr-Ca-Cu-O superconductors"
JAPANESE JOURNAL OF APPLIED PHYSICS,
vol. 28, no. 7, July 1989, pages L1204-L1206,
Tokyo, JP; T. HIKATA et al.: "Electromagnetic
properties and morphology of Ag-sheated
Bi-Pb-Sr-Ca-Cu-O superconducting wires"**

(56) References cited :
**JAPANESE JOURNAL OF APPLIED PHYSICS,
vol. 28, no. 1, January 1989, pages L82-L84,
Tokyo, JP; T. HIKATA et al.: "Ag-sheated Bi-
Pb-Sr-Ca-Cu-O superconducting wires with
high critical current density"**

(73) Proprietor : **SUMITOMO ELECTRIC
INDUSTRIES, LTD.
5-33, Kitahama 4-chome,
Chuo-ku
Osaka-shi, Osaka 541 (JP)**

(72) Inventor : **Mukai, Hidehito, C/o Osaka Works of
Sumitomo
Electric Industries Ltd.,
1-3 Shimaya 1-chome
Konohana-ku, Osaka (JP)**
Inventor : **Sato, Ken-ichi, C/o Osaka Works of
Sumitomo
Electric Industries Ltd.,
1-3 Shimaya 1-chome
Konohana-ku, Osaka (JP)**

(74) Representative : **KUHNEN, WACKER &
PARTNER
Alois-Steinecker-Strasse 22
D-85354 Freising (DE)**

## Description

Field of the invention

The present invention relates to the use of a superconducting wire as a current-carrying lead for a cryostat.

Description of the Background Art

In general, a current-carrying lead for a superconducting magnet, which is used at a temperature of 4.2 K, is formed of a copper pipe which is mainly composed of copper etc. Such a current-carrying lead is adapted to carry a current from an ordinary temperature region to a liquid helium temperature region. In such a current-carrying lead, however, heat is inevitably generated by specific resistance of coper, and a large quantity of helium is consumed upon energization.

In order to solve such a problem, the current-carrying lead may be formed of an oxide superconductor which exhibits superconductivity at a high temperature, to suppress heat generation upon energization.

However, even if the current-carrying lead is thus formed of an oxide superconductor to suppress heat generation upon energization, helium is still problematically consumed by conduction of heat from the ordinary temperature region to the liquid helium temperature region in a non-energized state.

Japanese Journal of Applied Physics, vol. 28, no. 1, January 1989, pages L 82 - L 84 discloses a method of forming an Ag-sheathed BiPbSrCaCuO superconducting wire by charging appropriate amounts of oxides and carbonates of the elements Bi, Pb, Sr, Ca and Cu into silver tubes, swaging and drawing of the composites, the fabrication into wires and the subsequent sintering of the final wires.

According to the present invention a superconducting wire comprising a copper oxide superconductor member is used as current carrying leads for a cryostat, wherein the ratio of the sectional area of said metal layer to hat of said oxide superconductor is at least 0.2 and not more than 1.0.

According to the present invention, the metal ratio is at least 0.2 since plastic working of the superconducting wire is impractically made difficult if the metal ratio is less than 0.2. Further, the metal ratio is not more than 1.0 since the quantity of heat transferred through the metal layer is so increased that the object of the present invention cannot be attained if the metal ratio exceeds 1.0.

A superconducting wire comprising a copper oxide superconductor member and a metal layer provided around the same can be produced by charging raw material powder for the oxide superconducting member in a metal pipe and performing plastic working and heat treatment on the raw material powder, for example. In order to attain a metal ratio which satisfies a value defined by the present invention in this method, it is necessary to appropriately select the outer and inner diameters of the metal pipe. If the metal ratio is larger than the value defined by the present invention, the metal layer can be partially removed by etching or the like, to bring the metal ratio into a range defined in the present invention.

The copper oxide superconductor employed in the present invention is not particularly restricted but may be prepared from a bismuth copper superconductor which is composed of Bi, Pb, Sr, Ca, Cu and O, for example.

A known example of such a bismuth superconductor is an oxide superconductor which has composition ratios of $Bi_aPb_bSr_cCa_dCu_e$, where $a + b : c : d : e$ = 1.7 to 2.8 : 1.7 to 2.5 : 1.7 to 2.8 : 3, for example.

The superconducting wire used in the present invention can be produced by a method of charging raw material powder for an oxide superconductor in a metal pipe and performing plastic working and heat treatment on the raw material powder to work the same into wire, for example, while heat treatment for preparing the raw material powder is preferably carried out in a decompressed atmosphere of the air.

It is preferable that the raw material powder is repeatedly subjected to plastik working and heat treatment at least twice in the form of wire.

When the copper oxide superconductor is prepared from a bismuth copper superconductive material, the metal layer is preferably formed of silver or silver alloy.

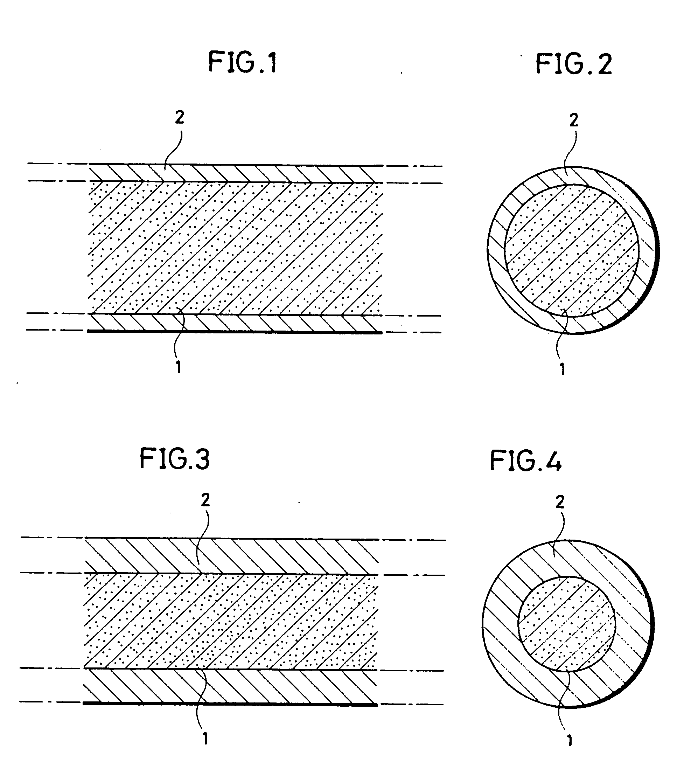

Fig. 1 is a longitudinal sectional view showing an embodiment used in the present invention, and Fig. 2 is a cross sectional view thereof. As shown in Figs. 1 and 2, a metal layer 2 is provided around an oxide superconductor member 1, so that the ratio of the sectional area of the metal layer 2 to that of the oxide superconductor member 1, i.e., the metal ratio, is at least 0.2 and not more than 1.0.

Fig. 3 is a longitudinal sectional view showing an example of conventional superconducting wire, and Fig. 4 is a cross sectional view thereof. In the conventional superconducting wire, the ratio of the sectional area of a metal layer 2 to that of an oxide superconductor member 1 is in excess of 1.0, as shown in Figs. 3 and 4.

According to the use of the present invention, the metal ratio is small as shown in Figs. 1 and 2 so that the sectional area of the metal layer 2 is smaller than that of the oxide superconductor member 1, whereby the quantity of heat transferred through the metal layer 2 into a cooling medium is reduced. Thus, it is possible to reduce consumption of the cooling medium such as liquid helium.

These and other objects, features, aspects and advantages of the present invention will become more apparent from the following detailed description of the present invention when taken in conjunction with the accompanying drawings.

## BRIEF DESCRIPTION OF THE DRAWINGS

Fig. 1 is a longitudinal sectional view showing an embodiment of the present invention;

Fig. 2 is a cross sectional view showing the embodiment of the present invention;

Fig. 3 is a longitudinal sectional view showing an example of conventional superconducting wire;

Fig. 4 is a cross sectional view showing the example of the conventional superconducting wire;

Fig. 5 is a sectional view showing an apparatus for measuring the quantities of liquid helium consumed when oxide superconducting wires produced according to the present invention are applied to current-carrying leads;

Fig. 6 is a sectional view showing a connected portion between a copper pipe and each oxide superconducting wire in the apparatus shown in Fig. 5; and

Fig. 7 is a sectional view showing a connected portion between each oxide superconducting wire and a metal superconducting wire in the apparatus shown in Fig. 5.

## DESCRIPTION OF THE PREFERRED EMBODIMENTS

Raw material powder was prepared by mixing $Bi_2O_3$, $PbO$, $SrCO_3$, $CaCO_3$ and $CuO$ so that Ba, Pb, Sr, Ca and Cu were in the ratios 1.8:0.4:2:2.2:3. The raw material powder was sintered twice in the atmospheric air at 750 to 850°C and thereafter sintered at 760°C under decompressed air of 33 Pa (1 Torr). Samples of the sintered powder were charged in silver pipes having dimensions/configurations shown in Table 1 respectively, drawn into wires of 2 mm in diameter, then rolled to be 0.7 mm in thickness, thereafter sintered at 845°C for 50 hours, further subjected to cold rolling and finally sintered at 840°C for 50 hours.

Table 1 also shows the metal ratios and critical current density values of the as-formed wires. It was impossible to perform plastic working on reference example 5.

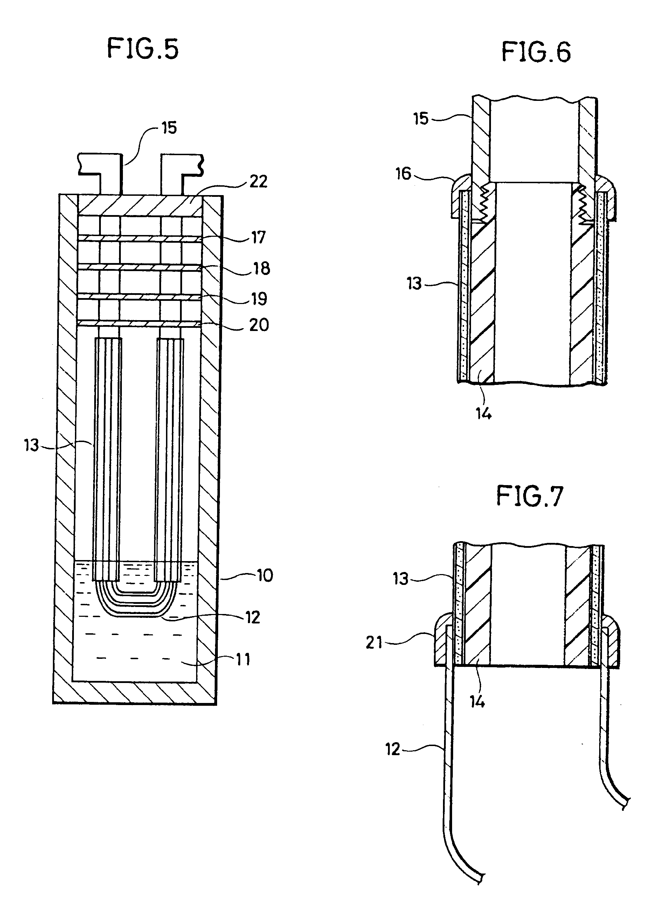

Then the superconducting wires were experimentally applied to current-carrying leads. Fig. 5 is a sectional view showing an apparatus which was employed for measuring the quantities of liquid helium consumed in relation to the current-carrying leads prepared from the aforementioned superconducting wires. Referring to Fig. 5, liquid helium 11 is contained in a lower part of a cryostat 10 serving as a vessel, and metal superconducting wires 12 are dipped in the liquid helium 11. Oxide superconducting wires 13 are connected to both ends of the metal superconducting wires 12, and copper pipes 15 are connected to upper ends of the oxide superconducting wires 13. These copper pipes 15 project from the upper portion of the cryostat 10 to the exterior, which is at the room temperature. A lid 22 is mounted on the upper portion of the cryostat 10. Four FRP fibreglass reinforced plastic plates 17, 18, 19 and 20 are arranged in the upper part of the cryostat 10, in order to shield the apparatus against heat. The copper pipes 15 pass through the FRP fibreglass reinforced plastic plates 17 to 20 and project to the exterior of the cryostat 10.

Fig. 6 is a sectional view showing a connected portion between each copper pipe 15 and each oxide superconducting wire 13 in the apparatus shown in Fig. 5. Referring to Fig. 6, a female screw is formed inside the lower end of the copper pipe 15, and a male screw formed on an FRP fibreglass reinforced plastic pipe 14 is engaged with the female screw. The oxide superconducting wire 13, which is in the form of a tape, is mounted around the FRP fibreglass reinforced plastic pipe 14. This oxide superconducting wire 13 is electrically connected with the copper pipe 15 by solder 16.

Fig. 7 is a sectional view showing a connected portion between each oxide superconducting wire 13 and each metal superconducting wire 12 in the apparatus shown in Fig. 5. Referring to Fig. 7, an end of the metal superconducting wire 12 is mounted on the oxide superconducting wire 13, which is mounted along the outer periphery of the FRP fibreglass reinforced plastic pipe 14, by solder 21. The oxide superconducting wire 13 is electrically connected with the metal superconducting wire 12 by the solder 21.

A plurality of oxide superconducting wires 13 are mounted around the FRP fibreglass reinforced plastic pipe 14, so that the critical currents thereof are 1000 A. In the apparatus shown in Fig. 5, the temperature of the region provided with the oxide superconducting wires 13 is not more than 80 K.

The apparatus shown in Fig. 5 was used to measure the quantities of liquid helium consumed when Examples 1 and 2 and reference examples 3 and 4 shown in Table 1 were applied to current-carrying leads. The measurement was performed with a current of 500 A. In each sample, an aggregate of the oxide superconducting wires was prepared in a length of 50 cm and critical current density was defined by voltage generation

of 1 μV with a distance of 40 cm between voltage terminals, while consumption of liquid helium was expressed in a relative ratio to the quantity of liquid helium consumed when a conventional current-carrying lead of a copper pipe was energized with a current of 500 A in current density of 1500 A/cm². The critical current density of the metal superconducting wires 12 was 300000 A/cm².

As clearly understood from the results shown in Table 1, the quantities of liquid helium consumed in relation to the superconducting wires of Examples 1 and 2 according to the present invention were extremely smaller than those of reference examples 3 and 4.

## Table 1

| | No. | Silver Pipe (mm ∅) | | Metal Ratio | Critical Current Density (A/cm²) | Helium Consumption |
|---|---|---|---|---|---|---|
| | | Outer Diameter | Inner Diameter | | | |
| Example | 1 | 12 | 10 | 0.80 | 6320 | 0.5 |
| | 2 | 12 | 11 | 0.23 | 5980 | 0.3 |
| Reference Example | 3 | 12 | 8 | 2.3 | 5500 | 2.2 |
| | 4 | 12 | 9.5 | 1.1 | 6300 | 1.7 |
| | 5 | 12 | 11.2 | 0.15 | Plastic Working Inavailable | |

According to the present invention, as hereinabove described, the ratio of the sectional area of the metal layer to that of the oxide superconductor member is made to satisfy a prescribed value to reduce the quantity of heat transferred through the metal layer, thereby reducing the quantity of liquid helium consumed by thermal conduction.

## Claims

1. The use of a superconducting wire comprising a copper oxide superconductor member showing an elevated critical temperature (Tc) and a metal layer provided around said copper oxide superconductor member as a current carrying leads of a cryostat, wherein the ratio of the sectional area of said metal layer to that of said copper oxide superconductor is at least 0.2 and not more than 1.0.

2. The use of a superconducting wire in accordance with claim 1, wherein said copper oxide superconductor member is prepared from a bismuth copper superconductor composed of Bi, Pb, Sr, Ca, Cu and O.

3. The use of a superconducting wire in accordance with claim 2, wherein said bismuth copper superconductor has composition ratios expressed as $Bi_aPb_bSr_cCa_dCu_e$, where $(a + b) : c : d : e = 1.7$ to $2.8 : 1.7$ to $2.5 : 1.7$ to $2.8 : 3$.

4. The use of a superconducting wire according to any of claims 1 to 3, wherein said metal layer is formed of silver or silver alloy.

## Patentansprüche

1. Die Verwendung eines supraleitenden Drahtes, welcher ein Kupferoxid-Supraleiterelement, das eine erhöhte kritische Temperatur (Tc) zeigt, und eine Metallschicht, welche um das Kupferoxid-Supraleiterelement herum zur Verfügung gestellt wird, als eine stromführende Leitung eines Kryostaten umfaßt, wobei das Verhältnis der Schnittfläche der Metallschicht zu der des Kupferoxid-Supraleiters wenigstens 0,2 und nicht mehr als 1,0 beträgt.

2. Die Verwendung eines supraleitenden Drahtes gemäß Anspruch 1, wobei das Rupferoxid-Supraleiterelement aus einem Wismut-Kupfer-Supraleiter, welcher aus Bi, Pb, Sr, Ca, Cu und O zusammengesetzt ist, hergestellt wird.

3. Die Verwendung eines supraleitenden Drahtes gemäß Anspruch 2, wobei der Wismut-Kupfer-Supraleiter Mischungsverhältnisse, ausgedrückt als $Bi_aPb_bSr_cCa_dCu_e$, hat, wobei gilt: (a + b) : c : d : e = 1,7 bis 2,8 : 1,7 bis 2,5 : 1,7 bis 2,8 : 3.

4. Die Verwendung eines supraleitenden Drahtes gemäß einem der Ansprüche 1 bis 3, wobei die Metallschicht aus Silber oder einer Silberlegierung gebildet ist.

## Revendications

1. Utilisation d'un fil supraconducteur comprenant un élément supraconducteur d'oxyde de cuivre présentant une température critique élevée (Tc) et une couche métallique disposée autour dudit élément supraconducteur d'oxyde de cuivre en tant que conducteur parcouru par le courant d'un cryostat, dans lequel le rapport de la zone sectionnelle de ladite couche métallique par rapport à celle du supraconducteur d'oxyde de cuivre est de 0,2 au minimum et ne dépasse pas 1,0.

2. Utilisation d'un fil supraconducteur selon la revendication 1, dans lequel ledit élément supraconducteur d'oxyde de cuivre est préparé à partir d'un supraconducteur de bismuth et de cuivre composé de Bi, Pb, Sr, Ca, Cu et O.

3. Utilisation d'un fil supraconducteur selon la revendication 2, dans lequel ledit supraconducteur de bismuth et de cuivre présente des rapports de composition exprimés sous la forme de $Bi_aPb_bSr_cCa_dCu_e$, où (a + b) : c : d : e = 1,7 à 2,8 : 1,7 à 2,5 : 1,7 à 2,8 : 3.

4. Utilisation d'un fil supraconducteur selon l'une des revendications 1 à 3, dans lequel ladite couche métallique est formée d'argent ou d'alliage d'argent.

## FIG.1

## FIG.2

## FIG.3

## FIG.4

## FIG.5

## FIG.6

## FIG.7